Europäisches Patentamt

European Patent Office

Office européen des brevets

(19)

(11) **EP 0 707 198 B1**

(12) **EUROPÄISCHE PATENTSCHRIFT**

(45) Veröffentlichungstag und Bekanntmachung des Hinweises auf die Patenterteilung:
**22.12.1999 Patentblatt 1999/51**

(51) Int Cl.[6]: **G01D 18/00**, G01R 31/28

(21) Anmeldenummer: **95710017.5**

(22) Anmeldetag: **09.09.1995**

(54) **Positionsmesseinrichtung**

Position-measuring device

Dispositif de mesure de position

(84) Benannte Vertragsstaaten:
**AT CH DE FR GB IT LI**

(30) Priorität: **13.10.1994 DE 4436546**

(43) Veröffentlichungstag der Anmeldung:
**17.04.1996 Patentblatt 1996/16**

(73) Patentinhaber: **Dr. Johannes Heidenhain GmbH
83292 Traunreut (DE)**

(72) Erfinder: **Strasser, Erich
D-83308 Trostberg (DE)**

(56) Entgegenhaltungen:
EP-A- 0 036 976          EP-A- 0 057 368
EP-A- 0 352 643

• **IBM TECHNICAL DISCLOSURE BULLETIN, Bd.
18, Nr. 11, April 1976 ARMONK, NEW YORK,
USA, Seiten 3572-3573, R.L.SCHAAF
'Automatically checked photoelectric sensing
apparatus.'**

## Beschreibung

Die Erfindung betrifft eine Positionsmeßeinrichtung mit einer Abtasteinrichtung zur Erzeugung von analogen positionsabhängigen Abtastsignalen, die mittels einer Triggerstufe digitalisiert werden.

Aus der DE 30 10 611 C2 ist eine derartige Positionsmeßeinrichtung bekannt. Zur Überprüfung der Einstellung der Triggerschwelle der Triggerstufe ist eine Prüfeinrichtung vorgesehen, durch welche die Triggerschwelle mittels Anlegen einer Prüfspannung angehoben oder abgesenkt wird. Durch Variation der Prüfspannung können unterschiedliche Prüfbereiche wie Grob- und Feinprüfbereich ausgewählt werden.

Aus der EP 0 057 368 A2 ist eine ähnliche Positionsmeßeinrichtung bekannt. Zur Überprüfung der Einstellung der Triggerschwellen wird den Triggerstufen ein Prüfsignal in Form einer Wechselspannung zugeführt. Das sich daraus ergebende Tastverhältnis des Ausgangssignals der Triggerstufen dient zur Beurteilung der Einstellung der Triggerschwellen.

Der Erfindung liegt die Aufgabe zugrunde, eine Positionsmeßeinrichtung mit einer Prüfeinrichtung anzugeben, bei der auch ein Ausfall der Triggerstufe eindeutig erkannt werden kann.

Diese Aufgabe wird erfindungsgemäß durch die Merkmale des Anspruches 1 gelöst.

Durch die erfindungsgemäße Positionsmeßeinrichtung können auf einfache Weise Fehler der Abtasteinrichtung sowie Fehler der Triggerstufe erkannt werden. Die zur Prüfung erforderlichen Prüfspannungen sind vorzugsweise fest vorgegeben, wodurch ein schneller Prüfvorgang gewährleistet ist, der auch beim Anwender der Positionsmeßeinrichtung durchgeführt werden kann.

Vorteilhafte Ausbildungen der Erfindung entnimmt man den abhängigen Ansprüchen.

Ausführungsbeispiele der Erfindung werden anhand der Zeichnung näher erläutert.

Es zeigen

Figur 1      schematisch eine absolute Längenmeßeinrichtung mit einer erfindungsgemäßen Prüfeinrichtung,

Figur 2a bis 2e      Signaldiagramme,

Figur 3      ein weiteres Signaldiagramm,

Figur 4      eine weitere absolute Längenmeßeinrichtung mit einer besonders vorteilhaften Prüfeinrichtung,

Figur 5      eine schematische Darstellung einer weiteren absoluten Längenmeßeinrichtung mit einer Prüfeinrichtung und

Figur 6a bis 6e      Signaldiagramme.

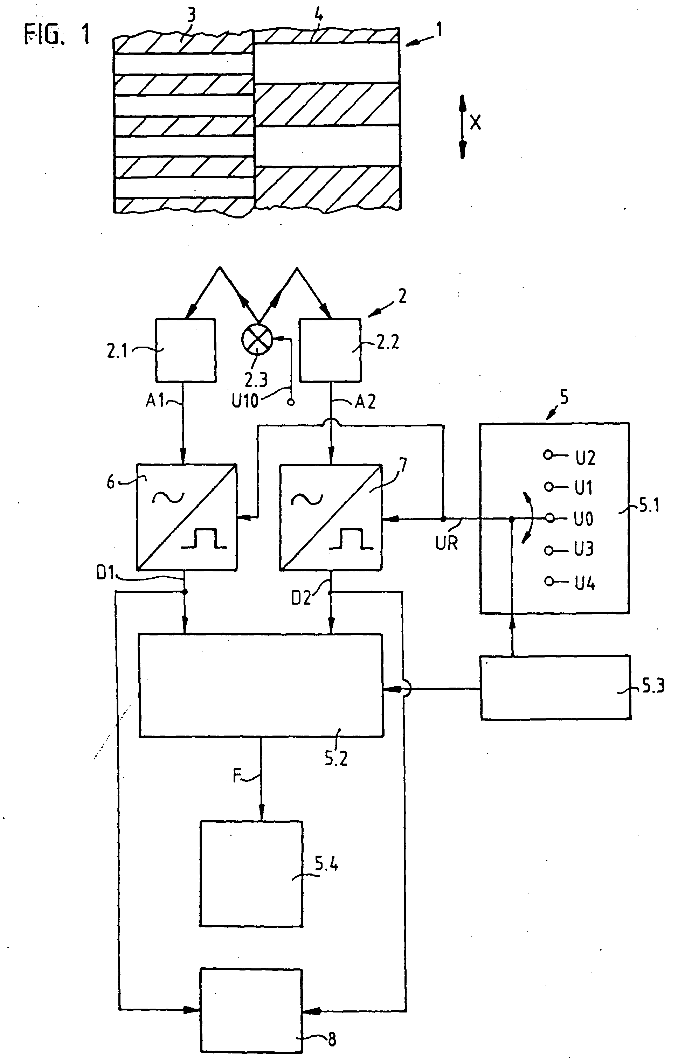

Die in Figur 1 dargestellte absolute Längenmeßeinrichtung besteht aus einer Maßverkörperung 1, die relativ zu einer Abtasteinheit 2 in Meßrichtung X verschiebbar angeordnet ist. Die Maßverkörperung 1 besteht in bekannter Weise aus mehreren, nebeneinander angeordneten Teilungsspuren 3 und 4. Jede Teilungsspur 3, 4 besteht aus abwechselnd reflektierenden und nicht reflektierenden Bereichen, so daß das von einer Lichtquelle 2.3 ausgesandte Licht moduliert auf Detektoren 2.1 und 2.2 der Abtasteinheit 2 trifft und positionsabhängige analoge elektrische Abtastsignale A1 und A2 erzeugt werden.

Zur Auswertung der Abtastsignale A1, A2 ist jedem Detektor 2.1, 2.2 eine Triggerstufe 6, 7 nachgeordnet. Aus den getriggerten, d.h. digitalisierten Abtastsignalen D1, D2 wird in einer Auswerteeinheit 8 in an sich bekannter Weise die Absolutposition bestimmt.

Jede Triggerstufe 6, 7 ist ein Vergleicher, auch Komparator genannt, der die Amplitude des anstehenden Abtastsignales A1, A2 mit einer ebenfalls anstehenden Triggerschwellenspannung UR vergleicht. Wenn die Amplitude des Abtastsignales A1 bei der gezeigten invertierenden Triggerstufe 6 größer ist als die Amplitude der Triggerschwelle UR, so wird am Ausgang der Triggerstufe 6 der Signalpegel "logisch 0" ausgegeben, bei A1<UR wird der Signalpegel "1" ausgegeben. Ebenso verhalten sich die Signalpegel des digitalisierten Abtastsignales D2 am Ausgang der Triggerstufe 7.

Erfindungsgemäß ist eine Prüfeinrichtung 5 vorgesehen, mit der die Triggerschwelle UR in fünf Stufen über eine Schalteinrichtung 5.1 verändert werden kann. In Abhängigkeit der eingestellten Triggerschwelle UR erfolgt die später noch im Detail beschriebene Überprüfung der getriggerten Abtastsignale D1, D2 mittels einer Logikschaltung 5.2. Die Schalteinrichtung 5.1 wird von einer Steuereinrichtung 5.3 angesteuert, die Synchronisation zwischen Schalterstellung und Logik 5.2 erfolgt ebenfalls über die Steuereinrichtung 5.3. Hat die Logik 5.2 einen fehlerhaften Zustand der Abtasteinheit 2 oder einer der Triggerstufen 6, 7 erkannt, wird ein Fehlersignal F zur Aktivierung einer Warneinrichtung 5.4 abgegeben.

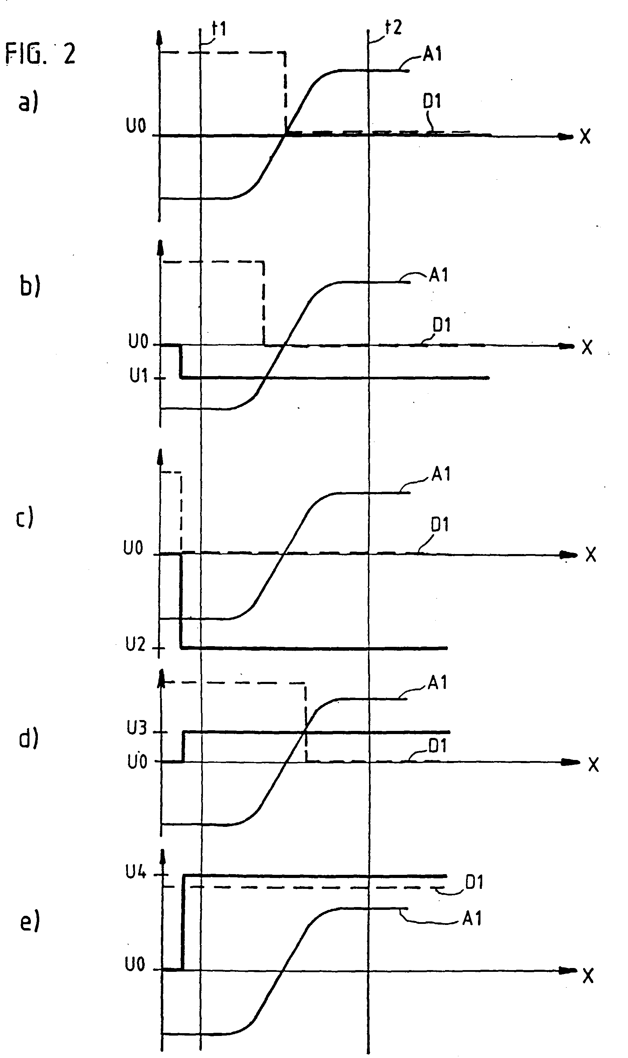

Zur Triggerung der analogen Abtastsignale A1, A2 beim normalen Meßbetrieb wird die Triggerschwelle UR=U0 = Mittenspannung der analogen Abtastsignale Al, A2 gesetzt. Am Beispiel des Abtastsignales A1 ist dieser Zustand in Figur 2 dargestellt. Durch diese übliche Triggerung entsteht das Rechtecksignal D1 mit den logischen Pegeln 0 (low) und 1 (high). Durch die Abtastung von mehreren Teilungsspuren 3, 4 erhält man eine Kombination von logischen Pegeln, welche als Digitalwort die absolute Position definieren. Um Fehlmessungen auszuschließen, erfolgt erfindungsgemäß die Überprüfung der korrekten Arbeitsweise der Abtasteinheit 2, insbesondere der Lichtquelle 2.3 sowie der Triggerstufen 6 und 7, indem an jede der Triggerstufen 6, 7 die Prüfspannungen U1 bis U4 als Triggerschwellenspannungen UR angelegt werden. Die sich dabei ergebenden Signalpegel des getriggerten Abtastsignales D1 in Abhängigkeit der momentanen Amplitude des Abtastsignales A1 ist in den Figuren 2a bis 2e dargestellt. t1 gibt den Zustand an, bei dem A1<U0 und somit D1=1 ist und t2 den Zustand, bei dem A1>U0 und somit D1=0 ist.

Figur 2b zeigt den Zustand, daß die Triggerschwelle UR von U0 auf U1 umgeschaltet wird. Die Amplitude von U1 ist so gewählt, daß sie innerhalb der maximalen und minimalen zulässigen Amplitude des Abtastsignales A1 liegt sowie kleiner ist als U0. Zum Zeitpunkt tl ist A1<U0, das heißt, daß im Normalbetrieb bei einer Verschiebung der Triggerschwelle UR nach unten sich D1 nicht ändern darf, also gemäß Figur 2b auf 1 bleiben muß. Ändert sich aber der logische Pegel des Ausgangssignales D1 von 1 auf 0, zeigt dies, daß ein Fehler bei der Erzeugung des Abtastsignales Al vorliegt, beispielsweise die Lichtquelle 2.3 defekt ist. Der Zeitpunkt t2 zeigt den Zustand, wenn A1>U0. Durch die Verschiebung der Triggerschwelle UR nach unten, ändert sich D1 nicht. Bei einem Fehlerfall wird sich D1 ändern, so daß ein Fehlersignal F erzeugt wird.

Figur 2c zeigt den Prüfschritt, bei dem die Triggerschwelle UR von U0 auf U2 geschaltet wird. U2 weist eine Amplitude auf, die außerhalb des zulässigen Amplitudenbereiches des Abtastsignales A1 im Normalbetrieb liegt und kleiner ist als U0. Während des Zustandes tl, bei dem A1<U0 ist, kann die Triggerstufe 6 überprüft werden, da sich bei korrekter Betriebsweise der Ausgangspegel D1 der Triggerstufe 6 von 1 auf 0 ändern muß. Ändert sich der Ausgangspegel D1 nicht, weist dies auf einen Defekt der Triggerstufe 6 hin und es wird ein Fehlersignal F an die Warneinrichtung 5.4 abgegeben. Wenn A1>U0 (Zustand t2) kann durch die Verschiebung der Triggerschwelle UR nach unten ebenfalls eine grobe Prüfung erfolgen, ein Fehlersignal F wird abgegeben, wenn sich D1 ändert.

Um auch eine Aussage über die korrekte Arbeitsweise der Abtasteinheit 2 sowie der Triggerstufe 6 während des Zustandes t2, bei dem A1>U0 ist zu bekommen, wird die Triggerschwelle UR mittels der Schalteinrichtung 5.1 auch in die positive Richtung verschoben. Gemäß Figur 2d wird die Triggerschwelle UR auf U3 angehoben. U3 besitzt eine Amplitude, die innerhalb der maximal und minimal zulässigen Amplitude des Abtastsignales A1 liegt, aber größer ist als U0. Im Zustand t2 (A1>U0) gemäß Figur 2d wird ersichtlich, daß sich bei korrekter Arbeitsweise der Abtasteinheit 2 der Ausgangspegel D1 der Triggerstufe 6 nicht ändern darf. Erfolgt dagegen ein Wechsel des Ausgangssignales D1 von 0 auf 1, zeigt dies, daß die Amplitude des analogen Abtastsignales A1 zu gering ist, und es wird ein Fehlersignal F erzeugt. Ändert sich D1 im Zustand t1, wird ebenfalls ein Fehlersignal F erzeugt.

Im letzten Prüfschritt gemäß Figur 2e wird die Triggerschwelle UR von U0 auf U4 umgeschaltet, wobei die Amplitude von U4 außerhalb des zulässigen Amplitudenbereichs des Abtastsignales A1 liegt und größer ist als U0. Beim Zustand t1 (A1<U0) wird ein Fehlersignal F abgegeben, wenn sich D1 ändert. Beim Zustand t2 (A1>U0) wird die korrekte Arbeitsweise der Triggerstufe 6 geprüft, indem überprüft wird, ob sich der logische Ausgangspegel D1 der Triggerstufe 6 ändert. Wird eine Änderung festgestellt, so ist eine korrekte Arbeitsweise garantiert. Wird keine Änderung in der Logik 5.2 festgestellt, so wird über das Fehlersignal F eine Warneinrichtung 5.4 aktiviert.

Die Logik 5.2 ist derart organisiert, daß sie in folgenden Fällen sicher ein Fehlersignal F erzeugt:

1. Wenn bei UR=U0, D1=1 ist und
bei UR=U1, D1=0 wird.

2. Wenn bei UR=U0, D1=1 ist und
bei UR=U2, D1=1 bleibt.

3. Wenn bei UR=U0, D1=0 ist und
bei UR=U3, D1=1 wird.

4. Wenn bei UR=U0, D1=0 ist und
bei UR=U4, D1=0 bleibt.

Zusätzlich ist es sinnvoll, bei folgenden Fällen ebenfalls ein Fehlersignal F abzugeben:

5. Wenn bei UR=U0, D1=1 ist und
bei UR=U3, D1=0 wird.

6. Wenn bei UR=U0, D1=1 ist und
bei UR=U4, D1=0 wird.

7. Wenn bei UR=U0, D1=0 ist und
bei UR=U1, D1=1 wird.

8. Wenn bei UR=U0, D1=0 ist und
bei UR=U2, D1=1 wird.

Es ist ersichtlich, daß durch die Verwendung von zwei Prüfspannungen U1, U2 kleiner als U0 und zwei Prüfspannungen U3, U4 größer als U0 die Prüfung bei allen eindeutigen Signalzuständen des analogen Abtastsignales A1 möglich ist. Dies hat den Vorteil, daß die Prüfung in beinahe jeder beliebigen Relativlage zwischen Abtasteinheit 2 und Maßverkörperung 1 erfolgen kann. Besonders vorteilhaft ist es, wenn alle Triggerstufen 6, 7 gleichzeitig überprüft werden, also an alle Triggerstufen 6, 7 zum gleichen Zeitpunkt die gleiche Prüfspannung U1, U2, U3, U4 angelegt wird.

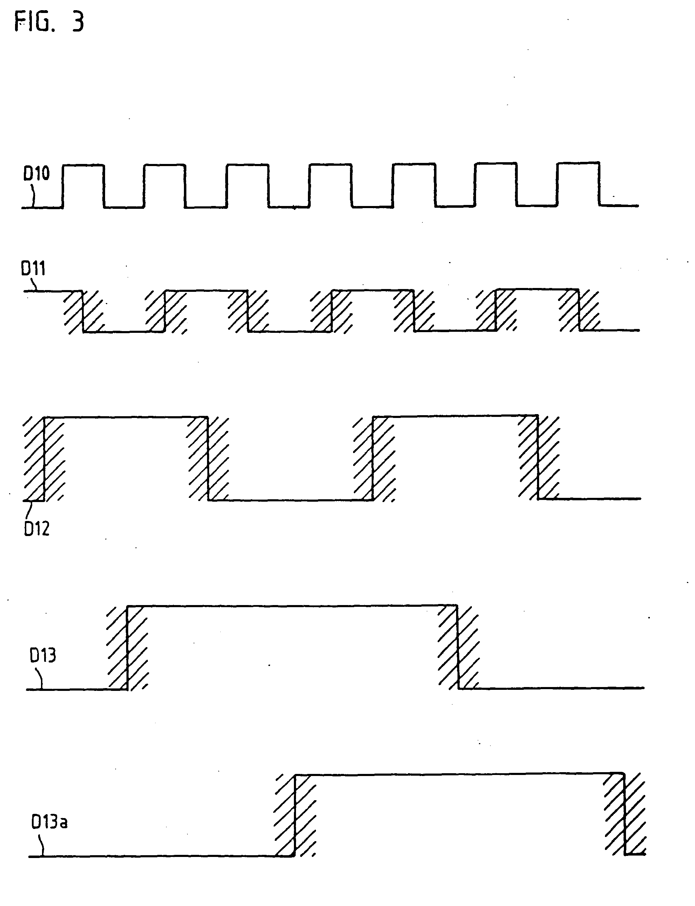

Aus dem Signaldiagramm in Figur 2a ist ersichtlich, daß das digitalisierte Abtastsignal D1 im Bereich um A1=U0 nicht eindeutig ist. Ebenso ist erkennbar, daß im Anstiegsbereich das analoge Abtastsignal A1 nicht eindeutig mit den Prüfspannungen U1 und U3 überprüft werden kann. Bei der Abtastung mehrerer Teilungsspuren 3, 4, welche einen Gray-Code innerhalb einer Code-Gruppe bilden ist gewährleistet, daß dieser nicht eindeutige Bereich nicht bei mehreren analogen Abtastsignalen A1, A2 gleichzeitig auftreten kann. Aus den Signalpegeln der getriggerten Abtastsignale D1, D2 ist es relativ einfach möglich, das einzige analoge Abtastsignal A1, A2 zu ermitteln, bei dem momentan kein eindeutiger Signalzustand vorliegt und bei dem sich das Ausgangssignal D1 der Triggerstufe 6 bei einer Verschiebung der Triggerschwelle UR von U0 auf U1 sowie von U0 auf U3 ändern darf, ohne daß ein Fehlersignal F erzeugt wird. Dies wird nachfolgend anhand der Figur 3 erläutert.

In Figur 3 sind die im Meßbetrieb von vier nicht gezeigten Abtasteinheiten erzeugten digitalisierten Abtastsignale D10, D11, D12, D13 und D13a dargestellt, die der Auswerteeinheit 8 zur Bildung der Momentanposition zugeführt werden. Das Abtastsignal D10 wird von der feinsten Teilungsspur abgeleitet, die auch als Inkrementalspur bezeichnet wird. In bekannter Weise kann das Abtastsignal D10 einem Zähler der Auswerteeinheit 8 zugeführt werden. Die weiteren Abtastsignale D11, D12, D13 und D13a dienen zur Bildung eines digitalen Codewortes, das zu jedem Zeitpunkt die Absolutposition bestimmt.

Die nicht eindeutigen Bereiche dieser Abtastsignale D11 bis D13a sind schraffiert dargestellt. Sie werden für jedes Abtastsignal D11 bis D13a in Abhängigkeit der Signalpegel (0 oder 1) der vorangehenden feineren digitalen Abtastsignale D10 bis D12 bestimmt:

    1. D11 ist nicht eindeutig, wenn
       D10=1

    2. D12 ist nicht eindeutig, wenn
       D10=0 und D11=1

    3. D13 ist nicht eindeutig, wenn
       D10=0 und D11=0 und D12=1

    4. D13a ist nicht eindeutig, wenn
       D10=0 und D11=0 und D12=0

Allgemein gilt also:

Das Abtastsignal D1n ist nicht eindeutig und wird somit auch nicht überprüft bzw. wird kein Fehlersignal F an die Warneinrichtung 5.4 abgegeben, wenn folgende Bedingungen erfüllt sind:

$$D1k=1 \text{ mit } k=(n-1) \text{ für } n \geq 1$$

und

$$D1k=0 \text{ mit } k=0 \text{ bis } (n-2) \text{ für } n \geq 2$$

Das Abtastsignal D1na mit der gleichen Periodendauer wie das Abtastsignal D1n, nur um 90° dagegen phasenverschoben, ist nicht eindeutig und wird somit auch nicht überprüft, wenn folgende Bedingung erfüllt ist:

$$D1k=0 \text{ mit } k=0 \text{ bis } (n-1) \text{ für } n \geq 1$$

Das in Figur 3 dargestellte getriggerte Abtastsignal D13a wird bei absoluten Positionsmeßsystemen, insbesondere bei Drehgebern mit mehreren über Getriebe miteinander verbundenen Codescheiben zur Synchronisation zwischen zwei Codegruppen verwendet. Diese Synchronisation zwischen zwei Codegruppen unterschiedlicher Auflösung ist beispielsweise in der DE 27 58 535 B1, DE 29 38 318 C3, DE 33 22 897 C2 sowie der DE 37 34 938 C2 erläutert.

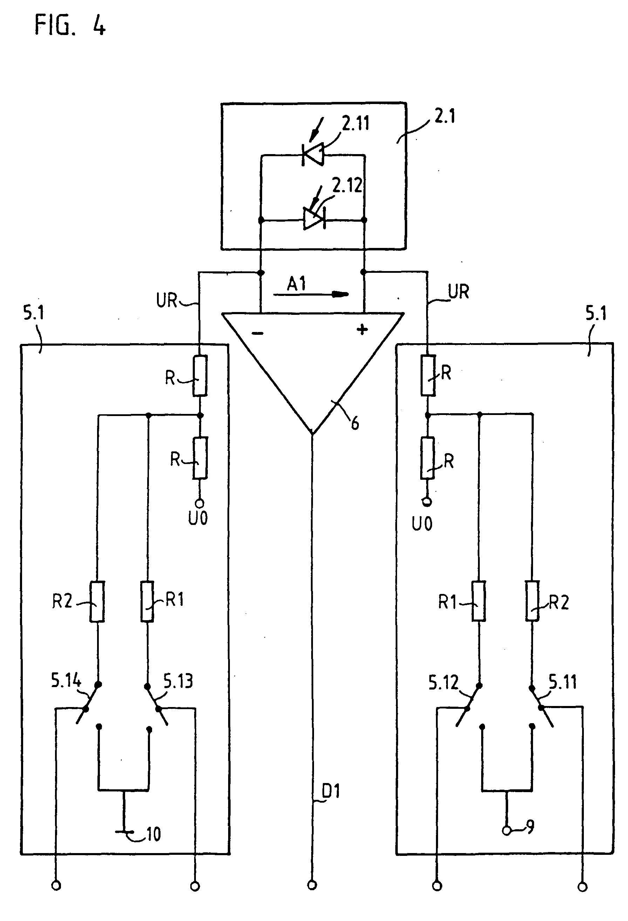

Anhand des Prinzipschaltbildes gemäß Figur 1 wurde die Erfindung im Detail erläutert. In Figur 4 ist eine besonders vorteilhafte Schaltung dargestellt. Der Detektor 2.1 zur Erzeugung eines analogen Abtastsignales AI in Form einer an den beiden Eingängen der Triggerstufe 6 anstehenden Spannung besteht aus einer an sich bekannten Parallelschaltung zweier Fotoelemente 2.11 und 2.12, die antiparallel verschaltet sind. Zur Veränderung der Triggerschwellenspannung UR an den Eingängen der Triggerstufe 6 ist die Schalteinrichtung 5.1 in einen rechten und linken Teil aufgeteilt. Jeder Teil enthält zwei Schalter 5.11, 5.12 sowie 5.13, 5.14, die im normalen Meßbetrieb alle offen sind, so daß an jedem der Eingänge der Triggerstufe 6 die Triggerschwelle U0 ansteht. Zur erfindungsgemäßen Prüfung werden die Schalter 5.11 bis 5.14 nacheinander geschlossen, so daß bei geschlossenem Schalter 5.11 die Triggerschwelle UR von U0 auf U4 angehoben wird, da eine Verbindung zwischen dem positiven (+) Eingang der Triggerstufe 6 und einer Spannungsquelle 9 hergestellt wird. Bei geschlossenem Schalter 5.12 wird die Triggerschwelle von U0 auf U3 angehoben. Bei geschlossenem Schalter 5.13 erfolgt eine Absenkung der Triggerschwelle von U0 auf U1, indem eine Verbindung zwischen dem invertierenden Eingang (-) der Triggerstufe 6 und Masse 10 hergestellt wird. Eine weitere Absenkung der Triggerschwelle von U0 auf U2 erfolgt durch Schließen des Schalters 5.14.

Die Widerstände R sowie R1 und R2 bilden dabei Spannungsteiler und sind derart gewählt, daß die Triggerschwellen U1, U2, U3, U4 relativ zum analogen Abtastsignal A1 die zu Figur 2 erörterten Größen aufweisen.

Die Ansteuerung der Schalter 5.11 bis 5.14 erfolgt durch die in Figur 1 dargestellte Steuereinrichtung 5.3.

Anstelle der besonders vorteilhaften Umschaltung auf vorgegebene Triggerschwellenspannungen U1 bis U4 ist gemäß der Erfindung auch eine beispielsweise stufenlose Verschiebung der Triggerschwellenspannung UR möglich. Bei der Verschiebung wird überprüft, bei welcher Triggerschwellenspannung UR sich der Zustand des getriggerten Abtastsignales D1 ändert. Die Größe der Triggerschwellenspannung UR bei einer Änderung des Zustandes definiert die Momentanamplitude des Abtastsignales A1, wodurch beispielsweise ein Ausfall der Lichtquelle 2.3 rechtzeitig erkannt werden kann.

Die Erfindung ist nicht auf die beschriebene lichtelektrische Längenmeßeinrichtung beschränkt, sie ist insbesondere bei absoluten Winkelmeßeinrichtungen einsetzbar, bei denen mehrere Codescheiben über Untersetzungsgetriebe miteinander gekoppelt sind. Weiterhin kann die Erfindung auch bei magnetischen, induktiven sowie kapazitiven Positionsmeßeinrichtungen eingesetzt werden. Bei magnetischen Positionsmeßeinrichtungen werden die Abtastsignale A1, A2 von magnetoresistiven Elementen oder von Hallelementen erzeugt.

Die Prüfspannungen U0 bis U4 zur Generierung der Triggerschwelle UR werden vorzugsweise innerhalb der Positionsmeßeinrichtung erzeugt, es ist aber auch möglich, sie von einer externen Einrichtung der Positionsmeßeinrichtung zuzuführen.

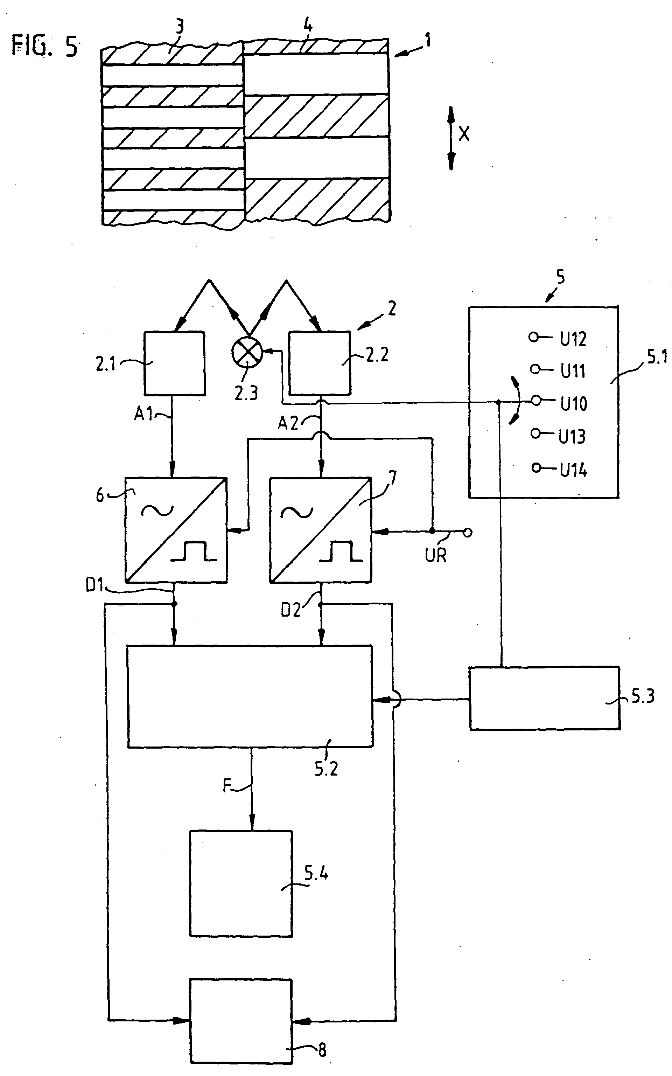

Bei den bisher beschriebenen Ausführungsformen leuchtet die Lichtquelle 2.3 während des gesamten Prüfvorganges mit konstanter Intensität. Dies wird dadurch erreicht, indem sie mit konstanter Spannung U10 betrieben wird, was in Figur 1 schematisch angedeutet ist. Aus den Figuren 2a bis 2e ist ersichtlich, daß mit der Prüfeinrichtung 5 die Lage der Triggerschwellenspannung UR relativ zum Abtastsignal AI verändert wird, was besonders einfach realisierbar ist. Den gleichen Effekt dieser relativen Veränderung zwischen Triggerschwellenspannung UR und Abtastsignal A1 erhält man aber auch, wenn die Triggerschwellenspannung UR konstant UO bleibt, und das Abtastsignal beeinflußt wird. Diese Beeinflussung kann erfolgen, indem dem Abtastsignal A1 direkt die Prüfspannungen U0 bis U4 überlagert werden oder die Strahlungsintensität der Lichtquelle 2.3 verändert wird. Wie diese Veränderung der Strahlungsintensität erfolgen kann, ist in Figur 5 dargestellt.

Mit der Prüfeinrichtung 5 wird die Strahlungsintensität der Lichtquelle 2.3 beeinflußt, indem die Betriebsspannung U10, U11, U12, U13, U14 verändert wird. Die Triggerschwellenspannung UR bleibt dagegen konstant bei UR=UO. Die Betriebsspannungen sind z. B. U14=0V, U13=3V, U10=4V, U11=8V und U12=16V.

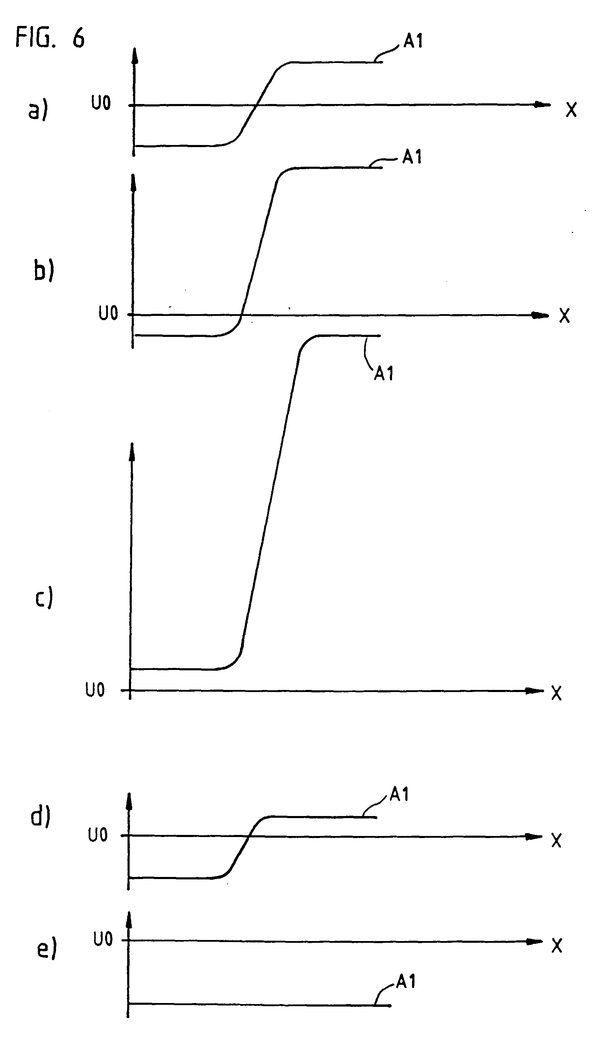

In Figur 6 sind die Signale der Positionsmeßeinrichtung gemäß Figur 5 dargestellt. Mit A1 ist auch hier das Abtastsignal bezeichnet, das während der Relativbewegung zwischen der Maßverkörperung 1 und der Abtasteinheit 2 entsteht.

In Figur 6a ist der Normalbetrieb gezeigt mit Betriebsspannung der Lichtquelle U10=4V. In Figur 6b ist ein erster Prüfzustand dargestellt, bei dem die Betriebsspannung der Lichtquelle U11=8V ist. Der Zustand des getriggerten Signales D1 darf sich gegenüber dem Normalbetrieb nicht ändern, ansonsten erfolgt die Erzeugung eines Fehlersignales.

In Figur 6c ist ein zweiter Prüfzustand dargestellt, bei dem die Betriebsspannung der Lichtquelle U12=16V ist, das gesamte Abtastsignal A1 also über die Triggerschwellenspannung U0 gehoben wird. Bei korrekt arbeitender Triggerstufe 6 nimmt das getriggerte Abtastsignal D1 den Zustand "1" an.

In Figur 6d ist ein dritter Prüfzustand dargestellt, bei dem die Betriebsspannung der Lichtquelle U13=3V ist. Auch hier darf sich der Zustand des getriggerten Signales D1 gegenüber dem Normalbetrieb nicht ändern.

In Figur 6e ist ein vierter Prüfzustand dargestellt, bei dem die Betriebsspannung der Lichtquelle U14=0V ist, das Abtastsignal A1 also unter die Triggerschwellenspannung U0 gesenkt wird. Bei korrekt arbeitender Triggerstufe 6 nimmt das getriggerte Abtastsignal D1 den Zustand "0" an.

Bei Positionsmeßeinrichtungen, die auf dem magnetischen Abtastprinzip beruhen, kann die Intensität des Abtastsignales beispielsweise durch ein variables Magnetfeld (Spule) gezielt relativ zur Triggerschwellenspannung verändert werden. Die Signalintensität könnte aber auch durch Abstandsänderung zwischen der Maßverkörperung und der Abtasteinheit (magnetoresistive Elemente oder Hallelemente) variiert werden.

## Patentansprüche

1. Positionsmeßeinrichtung mit einer Abtasteinheit (2) zur Erzeugung von positionsabhängigen analogen Abtastsignalen (A1, A2), die zur Erzeugung von digitalen Abtastsignalen (D1, D2) und zur Bildung von Positionsmeßwerten mittels jeweils einer Triggerstufe (6, 7) bei einer vorgegebenen Triggerschwellenspannung (UR) getriggert werden, wobei eine Prüfeinrichtung (5) vorgesehen ist, mit der die Triggerschwellenspannung (UR) oder das analoge Abtastsignal (AI, A2) durch mehrere Prüfspannungen (U1, U2, U3, U4; U10, U11, U12, U13, U14) beeinflußt wird, so daß in einem Zustand die Triggerschwellenspannung (UR) innerhalb der Amplitude des analogen Abtastsignales (A1, A2) und in einem weiteren Zustand außerhalb der Amplitude des analogen Abtastsignales (A1, A2) liegt, und in der Prüfeinrichtung (5) eine Logik (5.2) vorgesehen ist, welche bei Veränderung der Prüfspannung (U1, U2, U3, U4; U10, U11, U12, U13, U14) den Zustand des digitalen Abtastsignales (D1, D2) überwacht und von der in Abhängigkeit einer Zustandsänderung ein Fehlersignal (F) erzeugt wird.

2. Positionsmeßeinrichtung nach Anspruch 1, dadurch gekennzeichnet, daß mittels der Prüfeinrichtung (5) die Triggerschwellenspannung (UR) ausgehend von einer Mittenspannung (UO) auf vier Prüfspannungen (U1, U2, U3, U4) umgeschaltet wird, wobei zwei Prüfspannungen (U1, U3) innerhalb der im Normalbetrieb zulässigen Amplitude des analogen Abtastsignales (A1, A2) liegen, wovon die eine kleiner und die andere größer ist als die Mittenspannung (UO), und daß weiterhin zwei Prüfspannungen (U2, U4) außerhalb der im Normalbetrieb zulässigen Amplitude des analogen Abtastsignales (A1, A2) liegen, wovon die eine kleiner und die andere größer als die Mittenspannung (UO) ist.

3. Positionsmeßeinrichtung nach Anspruch 2, dadurch gekennzeichnet, daß von der Prüfeinrichtung (5) ein Fehlersignal (F) erzeugt wird, wenn sich der Zustand des digitalen Abtastsignales (D1, D2) bei der Umschaltung auf eine der beiden Prüfspannungen (U1, U3), welche innerhalb der im Normalbetrieb zulässigen Amplitude des analogen Abtastsignales (A1, A2) liegen, ändert und bei der Umschaltung auf eine Prüfspannung (U2, U4) außerhalb der im Normalbetrieb zulässigen Amplitude und in Richtung der Momentanamplitude des analogen Abtastsignales (A1, A2) ein Fehlersignal (F) erzeugt wird, wenn sich der Zustand des digitalen Abtastsignales (D1, D2) nicht ändert.

4. Positionsmeßeinrichtung nach einem der Ansprüche 1 bis 3, dadurch gekennzeichnet, daß die Abtasteinheit (2) eine Maßverkörperung (1) mit mehreren Teilungsspuren (3, 4) zur Erzeugung mehrerer positionsabhängiger analoger Abtastsignale (A1, A2) aufweist, wobei die Teilungsspuren (3, 4) einen Gray-Code bilden, und daß die analogen Abtastsignale (A1, A2) Triggerstufen (6, 7) zur Bildung mehrerer digitaler Abtastsignale (D1, D2) zugeführt werden, wobei an alle Triggerstufen (6, 7) zum gleichen Zeitpunkt die gleiche Prüfspannung (U1, U2, U3, U4) angelegt wird.

5. Positionsmeßeinrichtung nach Anspruch 4, dadurch gekennzeichnet, daß bei der Prüfung eines der analogen Abtastsignale (A1, A2) die Abgabe eines Fehlersignales (F) an eine Warneinrichtung (5.4) in Abhängigkeit der Zustände weiterer digitaler Abtastsignale (D1, D2) erfolgt.

6. Positionsmeßeinrichtung nach Anspruch 5, dadurch gekennzeichnet, daß bei der Prüfung des analogen Abtastsignales (A1, A2) der n-ten Teilungsspur kein Fehlersignal (F) abgegeben wird, wenn folgende Bedingungen erfüllt sind:

$$D1k = 1 \text{ mit } k = (n-1) \text{ für } n \geq 1$$

und

$$D1k = 0 \text{ mit } k = 0 \text{ bis } (n-2) \text{ für } n \geq 2$$

Wobei n die aufeinanderfolgenden Teilungsspuren kennzeichnet, je größer n, desto größer ist die Teilungsperiode der Teilungsspur.

7. Positionsmeßeinrichtung nach einem der vorhergehenden Ansprüche, dadurch gekennzeichnet, daß die Abtasteinheit (2) zumindest eine Lichtquelle (2.3) und eine Parallelschaltung zweier Fotoelemente (2.11, 2.12), die antiparallel zueinander geschaltet sind aufweist, wobei an beiden Eingängen (+, -) einer Triggerstufe (6) ein analoges Abtastsignal (A1) als Differenzspannung der beiden Fotoelemente (2.11, 2.12) ansteht und die Prüfspannungen (U1, U2, U3, U4) über zumindest einen dieser Eingänge (+, -) von der Prüfeinrichtung (5) zugeführt werden.

8. Positionsmeßeinrichtung nach Anspruch 1, dadurch gekennzeichnet, daß das analoge Abtastsignal (A1, A2) durch Anlegen mehrerer Prüfspannungen (U10, U11, U12, U13, U14) an eine Lichtquelle (2.3) der Abtasteinheit (2) beeinflußt wird.

## Claims

1. Position measuring device with a scanning unit (2) for producing position-dependent analogue scanning signals (A1, A2) which are triggered to produce digital scanning signals (D1, D2) and to form position measuring values by means of a trigger stage (6, 7) respectively at a prescribed trigger threshold voltage (UR), a testing device (5) being provided with which the trigger threshold voltage (UR) or the analogue scanning signal (A1, A2) is influenced by several test voltages (U1, U2, U3, U4; U10, U11, U12, U13, U14) so that in one state the trigger threshold voltage (UR) lies within the amplitude of the analogue scanning signal (A1, A2) and, in a further state, outwith the amplitude of the analogue scanning signal (A1, A2) and a logic (5.2) is provided in the testing device (5) which logic monitors the state of the digital scanning signal (D1, D2) when the testing voltage (U1, U2, U3, U4; U10, U11, U12, U13, U14) changes and from which logic a fault signal (F) is produced depending on a change in state.

2. Position measuring device according to claim 1, characterised in that by means of the testing device (5) the trigger threshold voltage (UR) is switched over starting from a middle voltage (U0) to four testing voltages (U1, U2, U3, U4), two testing voltages (U1, U3) lying within the amplitude of the analogue scanning signal (A1, A2), which is permitted in normal operation, one of said testing voltages being smaller than the middle voltage (U0) and the other being greater, and in that furthermore two testing voltages (U2, U4) lie outwith the amplitude of the analogue scanning signals (A1, A2) which is permitted in normal operation, one of said testing voltages being smaller than the middle voltage (U0) and the other being greater.

3. Position measuring device according to claim 2, characterised in that a fault signal (F) is produced from the testing device (5) when the state of the digital scanning signal (D1, D2) is changed upon switching over to one of the two testing voltages (U1, U3) which lie within the amplitude of the analogue scanning signal (A1, A2) which is permitted in normal operation and a fault signal (F) is produced upon switching over to one testing voltage (U2, U4) outwith the amplitude which is permitted in normal operation and in the direction of the momentary amplitude of the analogue scanning signal (A1, A2) if the state of the digital scanning signal (D1, D2) is not changed.

4. Position measuring device according to one of the claims 1 to 3, characterised in that the scanning unit (2) has a material measure (1) with several dividing tracks (3, 4) for producing several position-dependent analogue scanning signals (A1, A2), the dividing tracks (3, 4) forming a Gray code, and in that the analogue scanning signals (A1, A2) are supplied to trigger stages (6, 7) to form several digital scanning signals (D1, D2), the same testing voltage (U1, U2, U3, U4) being applied to all of the trigger stages (6, 7) at the same point in time.

5. Position measuring device according to claim 4, characterised in that when testing one of the analogue scanning signals (A1, A2), the emission of a fault signal (F) to a warning device (5.4) is effected depending upon the states of further digital scanning signals (D1, D2).

6. Position measuring device according to claim 5, characterised in that when testing the analogue scanning signal (A1, A2) of the n-th dividing track no fault signal (F) is emitted if the following conditions are fulfilled:

$$D1k = 1 \text{ with } k = (n-1) \text{ for } n \geq 1$$

and

$$D1k = 0 \text{ with } k = 0 \text{ to } (n-2) \text{ for } n \geq 2$$

n characterising the successive dividing tracks, the greater n is, the greater is the dividing period of the dividing track.

7. Position measuring device according to one of the preceding claims, characterised in that the scanning unit (2) has at least one light source (2.3) and a parallel circuit of two photocells (2.11, 2.12) which are connected to each other in an anti-parallel manner, an analogue scanning signal (AI) being present at both inputs (+, -) of a trigger stage (6) as a differential voltage of both photocells (2.11, 2.12) and the testing voltages (U1, U2, U3, U4) being supplied via at least one of these inputs (+, -) from the testing device (5).

8. Position measuring device according to claim 1, characterised in that the analogue scanning signal (A1, A2) is influenced by applying several testing voltages (U10, U11, U12, U13, U14) to a light source (2.3) of the scanning unit (2).

**Revendications**

1. Dispositif de mesure de position comprenant une unité de palpage (2) pour produire des signaux de palpage (A1, A2) analogiques dépendants de la position qui, pour produire des signaux de palpage (D1, D2) numériques et former des valeurs de mesure de position sont convertis par déclenchement à une tension de seuil (UR) prédéterminée, au moyen chaque fois d'un étage déclencheur (6, 7), un dispositif de contrôle (5) étant prévu, à l'aide duquel on agit sur la tension de seuil de déclenchement (UR) ou sur le signal de palpage (A1, A2) analogique à l'aide de plusieurs tensions de contrôle (U1, U2, U3, U4; U10, U11, U12, U13, U14), de telle sorte que, dans un état, la tension de seuil de déclenchement (UR) soit située à l'intérieur de l'amplitude du signal de palpage analogique (A1, A2) et que dans un au tre état, elle soit située en dehors de l'amplitude du signal de palpage (A1, A2) analogique et, une logique (5.2) qui surveille l'état du signal de palpage numérique (D1, D2) lors du changement de la tension de contrôle (U1, U2, U3, U4; U10, U11, U12, U13, U14) et délivre un signal d'erreur (F) en relation avec le changement d'état étant prévue dans le dispositif de contrôle (5) .

2. Dispositif de mesure de position selon la revendication 1, caractérisé par le fait qu'à l'aide du dispositif de contrôle (5) on commute la tension de seuil de déclenchement (UR) depuis une tension médiane (UO) sur quatre tensions de contrôle (U1, U2, U3, U4), deux tensions de contrôle (U1, U3) étant situées à l'intérieur de l'amplitude du signal de palpage (A1, A2) analogique admissible en fonctionnement normal, l'une des tensions étant plus faible et l'autre plus forte que la tension médiane (UO) et par le fait que deux autres tensions de contrôle (U2, U4) sont situées à l'extérieur de l'amplitude du signal de palpage (A1, A2) analogique admissible en fonctionnement normal, l'une des tensions étant plus faible et l'autre plus forte que la tension médiane (UO).

3. Dispositif de mesure de position selon la revendication 2, caractérisé par le fait que le dispositif de contrôle (5) délivre un signal d'erreur (F) lorsque l'état du signal de palpage (D1, D2) numérique lors de la commutation sur l'une des deux tensions de contrôle (U1, U3) qui se trouvent à l'intérieur de l'amplitude du signal de palpage (A1, A2) analogique admissible en fonctionnement normal, et que lors de la commutation sur une tension de contrôle (U2, U4) à l'extérieur de l'amplitude admissible en fonctionnement normal et dans le sens de l'amplitude instantanée du signal de palpage (A1, A2) analogique, un signal d'erreur (F) est produit lorsque l'état du signal de palpage (D1, D2) ne change pas.

4. Dispositif de mesure de position selon une des revendications 1 à 3, caractérisé par le fait que l'unité de palpage (2) comprend une mesure matérialisée (1) avec plusieurs pistes à divisions (3, 4) pour produire plusieurs signaux de palpage (A1, A2) analogiques dépendants de la position, les pistes à divisions (3, 4) formant un code-Gray et.par le fait que les signaux de palpage (A1, A2) analogiques sont transmis à des étages déclencheurs (6, 7) pour former plusieurs signaux (D1, D2) numériques, la même tension de contrôle (U1, U2, U3, U4) étant appliquée au même instant à tous les étages déclencheurs (6, 7).

5. Dispositif de mesure de position selon la revendication 4, caractérisé par le fait que lors du contrôle de l'un des signaux de palpage (A1, A2) analogiques la délivrance d'un signal d'erreur (F) à un dispositif d'alarme (5.4) a lieu en fonction des états de signaux de palpage (D1, D2) numériques supplémentaires.

6. Dispositif de mesure de position selon la revendication 5, caractérisé par le fait que lors du contrôle des signaux de palpage (A1, A2) analogiques de la n-ième piste à divisions aucun signal d'erreur (F) n'est émis lorsque les conditions suivantes sont satisfaites:

$$D1k = 1 \text{ avec } k = (n-1) \text{ pour } n \geq 1$$

et

$$D1k = 0 \text{ avec } k = 0 \text{ à } (n-21) \text{ pour } n \geq 2$$

n désignant les pistes à divisions successives, plus n étant grand et plus la période de division de la piste à divisions étant élevée.

7. Dispositif de mesure de position selon une des revendications précédentes, caractérisé par le fait que l'unité de palpage (2) comprend au moins une source de lumière (2.3) et un circuit parallèle de deux cellules photo-électriques (2.11, 2.12) en montage anti-parallèle, un signal de palpage (A1) analogique étant appliqué en tant que tension différentielle des deux cellules photo-électriques (2.11, 2.12) aux deux entrées (+, -) d'un étage déclencheur (6) et les tensions de contrôle (U1, U2, U3, U4) étant appliquées par au moins une de ces entrées (+, -) à partir du dispositif de contrôle (5).

8. Dispositif de mesure de position selon la revendication 1, caractérisé par le fait que l'on agit sur le signal de palpage (A1, A2) analogique en appliquant plusieurs tensions de contrôle (U10, U11, U12, U13, U14) à une source lumineuse (2.3) de l'unité de palpage (2).

FIG. 1

FIG. 2

a)

b)

c)

d)

e)

FIG. 3

## FIG. 4

FIG. 5

FIG. 6